# EUROPEAN PATENT SPECIFICATION

(11) **EP 3 730 536 B1**
(45) Date of publication and mention of the grant of the patent: **13.09.2023**
(21) Application number: 18890339.7
(22) Date of filing: 19.12.2018
(51) Int. Cl.: C08G 73/14, B32B 27/34, C08G 18/34, C08G 18/38, C08L 79/08, H01L 23/29, H01L 23/31

(54) **POLYAMIDE IMIDE RESIN, POLYAMIDE IMIDE RESIN COMPOSITION, AND SEMICONDUCTOR DEVICE USING POLYAMIDE IMIDE RESIN AND POLYAMIDE IMIDE RESIN COMPOSITION**
POLYAMIDIMIDHARZ, POLYAMIDIMIDHARZZUSAMMENSETZUNG UND HALBLEITERBAUELEMENT MIT DEM POLYAMIDIMIDHARZ UND DER POLYAMIDIMIDHARZZUSAMMENSETZUNG
RÉSINE POLYAMIDE-IMIDE, COMPOSITION DE RÉSINE POLYAMIDE-IMIDE ET DISPOSITIF SEMI-CONDUCTEUR FAISANT APPEL À UNE RÉSINE POLYAMIDE-IMIDE ET À UNE COMPOSITION DE RÉSINE POLYAMIDE-IMIDE

(30) Priority: 20.12.2017 WO PCT/JP2017/045692
(43) Date of publication of application: 28.10.2020
(73) Proprietor: Resonac Corporation, Tokyo (JP)
(72) Inventor: TAKEMORI, Daichi, Tokyo 100-6606 (JP); SATO, Eiichi, Tokyo 100-6606 (JP); SATO, Mizuki, Tokyo 100-6606 (JP)
(74) Representative: Hoffmann Eitle
(86) International application number: PCT/JP2018/046691
(87) International publication number: WO 2019/124414

(56) References cited:
- WO-A1-2013/108784
- JP-A- H 059 254
- JP-A- H0 532 892
- JP-A- H0 931 198
- JP-A- 2000 345 035
- JP-A- 2003 342 469
- US-A- 3 723 385

## Description

### TECHNICAL FIELD

Embodiments of the present invention relate to a polyamideimide resin and a polyamideimide resin composition having superior heat resistance and excellent flexibility and printability. Another embodiment of the present invention relates to a highly reliable semiconductor device that uses the polyamideimide resin or the polyamideimide resin composition.

### BACKGROUND ART

Polyamideimide resins are known as typical heat-resistant resins, and are used in a variety of applications. In addition to heat resistance, polyamideimide resins also exhibit excellent chemical resistance and mechanical properties. Consequently, polyamideimide resins are widely used in the field of electronics, for example, as the materials for surface protective films or interlayer insulating films or the like for semiconductor elements.

On the other hand, conventionally, molded cases of silicone gels have typically been used for sealing semiconductor elements. In recent years, the miniaturization of power semiconductor devices has progressed, and sealing with resin sealing members formed by conducting transfer molding or compression molding methods using a solid or liquid sealing resin is becoming mainstream.

However, power semiconductors having a resin sealing member formed using a solid or liquid sealing resin sometimes suffer from separation between the various members, such as between the resin sealing member and the substrate or the semiconductor element, in heat cycle testing. Accordingly, from the viewpoint of the reliability of semiconductor devices, improvements in the adhesion between the various members would be desirable.

In this regard, with the aim of improving the adhesion between resin sealing members and substrates or semiconductor elements, a method has been investigated in which a primer layer is formed between the various members using a resin material such as a low-elastic modulus polyamide resin, polyamideimide resin, or polyimide resin or the like, thereby ensuring superior adhesive strength and preventing separation between the various members during heat cycle testing (see Patent Document 1).

In the above method, formation of the primer layer is performed by applying a solution of the resin material dissolved in a solvent to the power module prior to sealing, and then drying the applied coating film. The method used for applying the resin material may employ typically methods such as dipping, potting, spray coating, and spin coating.

However, in recent years, as a result of increases in the current flowing through power semiconductor devices, and a change in substrate materials, for example from Si to SiC and the like, the amount of heat generated by power semiconductor devices themselves has been increasing. As a result, the temperatures required during heat cycle testing have tended to increase, meaning achieving satisfactory results with conventional resin materials has become difficult. Accordingly, a resin material capable of further improving the adhesion between the sealing resin member and the various members such as the substrate and semiconductor element would be desirable.

### PRIOR ART DOCUMENTS

### PATENT DOCUMENT

Patent Document 1: JP 2013-135061 A

### SUMMARY OF THE INVENTION

### PROBLEMS TO BE SOLVED BY THE INVENTION

In those cases where the glass transition temperature of the resin material used in forming the primer layer is lower than the maximum temperature of the heat cycle testing, the heat resistance is unsatisfactory, and ensuring favorable adhesion between the various members becomes difficult. As a result, separation tends to occur, for example, between the resin sealing member and the substrate or the semiconductor element. On the other hand, if a resin having a high glass transition temperature is used to improve the heat resistance of the resin material, then the flexibility of the film formed from the resin material tends to deteriorate. The flexibility of the film also affects the adhesion between the various members. Accordingly, in order to obtain excellent adhesion, achieving a balance between heat resistance and flexibility is necessary. Further, in those cases where a printing method is used for forming the primer layer, the resin material also requires superior printability.

In light of the above circumstances, the present invention provides a resin material that exhibits excellent heat resistance, flexibility and printability, and is capable of improving the adhesion between various members. Further, the present invention also provides a semiconductor device having superior reliability that is produced using the resin material.

### MEANS TO SOLVE THE PROBLEMS

The inventors of the present invention conducted various investigations using polyamideimide resins and polyamideimide resin compositions as the resin material, and discovered that a polyamideimide resin having specific structural units had a high glass transition temperature as well as having superior flexibility and printability. Moreover, they also discovered that when a polyamideimide resin having these specific structural units, or a resin composition that used the polyamideimide resin, was used to form a primer layer between various members, such as between a resin sealing member and a substrate or a semiconductor element, excellent adhesion could be achieved, thus enabling them to complete the present invention.

Embodiments of the present invention relate to the following aspects, but the present invention is not limited to the aspects described below.

One embodiment relates to a polyamideimide resin that is soluble in polar solvents at room temperature and has a glass transition temperature of 250°C or higher.

One embodiment relates to a polyamideimide resin containing a structural unit (Ia) derived from a compound represented by formula (I) and a structural unit (IIa) derived from a compound represented by formula (II), and having a glass transition temperature of 250°C or higher.

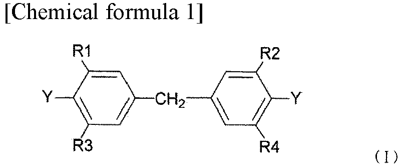

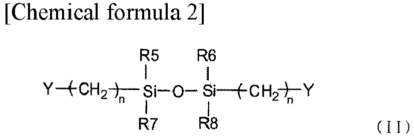

In formula (I) and formula (II), each of R1 to R4 independently represents an alkyl group of 3 to 9 carbon atoms having a branched structure, and each of R5 to R8 independently represents an alkyl group of 1 to 3 carbon atoms.

Each Y independently represents an amino group or an isocyanate group.

Further, n represents an integer of 1 to 6.

The polyamideimide resin described above preferably also contains a structural unit (IIIa) derived from a compound represented by formula (III).

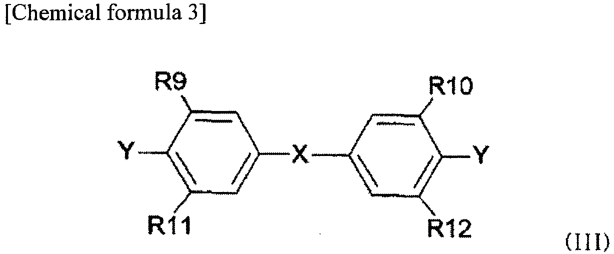

In formula (III), X represents a linking group selected from the group consisting of -O-, -S-, - SO₂-, -C(=O)- and -S(=O)-.

Each of R9 to R12 independently represents a hydrogen atom, or at least one substituent selected from the group consisting of alkyl groups of 1 to 9 carbon atoms, alkoxy groups of 1 to 9 carbon atoms and halogen atoms.

Each Y independently represents an amino group or an isocyanate group.

The polyamideimide resin described above preferably also contains a structural unit (IVa) derived from trimellitic anhydride or an acid halide thereof represented by formula (IV).

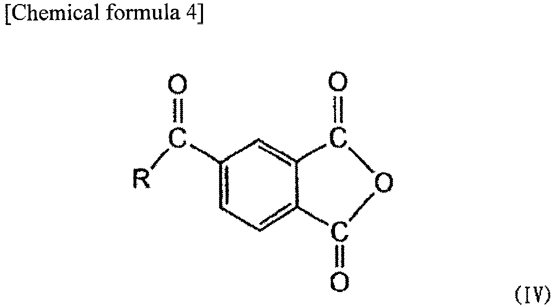

In formula (IV), R represents a hydroxyl group or a halogen atom.

Another embodiment relates to a polyamideimide resin composition containing the polyamideimide resin of an embodiment described above, and a solvent capable of dissolving the polyamideimide resin.

In the embodiment described above, the polyamideimide resin composition preferably also contains a coupling agent.

In a laminate obtained by forming a primer layer on a substrate using the polyamideimide resin composition described above, and then molding a resin sealing member on top of the primer layer, the shear strength at 250°C between the substrate and the resin sealing member is preferably at least 10 MPa.

The elastic modulus at 35°C of a film obtained using the polyamideimide resin composition described above is preferably within a range from 0.5 GPa to 3.0 GPa.

The polyamideimide resin composition described above preferably also contains a pigment. The pigment is preferably a white-colored powder. Further, the average particle size of the pigment is preferably less than 100 µm.

Another embodiment relates to a semiconductor device having a substrate, a semiconductor element mounted on the substrate, a primer layer provided on the semiconductor element-mounting surface of the substrate, and a resin sealing member provided on top of the primer layer, wherein the primer layer is formed using the polyamideimide resin or the polyamideimide resin composition of an embodiment described above.

### EFFECTS OF THE INVENTION

The present invention is able to provide a polyamideimide resin which is capable of maintaining favorable adhesion between various members even at high temperatures of 250°C, and also exhibits excellent heat resistance, flexibility and printability, as well as providing a resin composition that uses the polyamideimide resin.

### BRIEF DESCRIPTION OF THE DRAWINGS

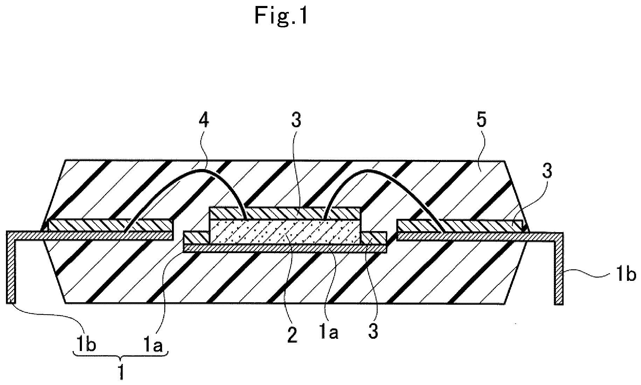

FIG. 1 is a schematic cross-sectional view illustrating one example of a semiconductor device that represents one embodiment of the present invention.

### EMBODIMENTS FOR CARRYING OUT THE INVENTION

### <Polyamideimide Resin>

A polyamideimide resin is a resin having amide linkages and imide linkages within the molecular framework. Polyamideimide resins can typically be obtained by a reaction between a diamine component or a diisocyanate component, and an acid component containing an anhydride of a compound having three carboxyl groups within the molecule (a tricarboxylic acid anhydride) or an acid halide thereof.

There are no particular limitations on the synthesis method, and for example, the polyamideimide resin can be obtained by reacting a diamine component and an acid component containing a tricarboxylic acid anhydride or an acid halide thereof to form a precursor (polyamic acid), and then subjecting the precursor to a dehydration cyclization. In those cases where a diisocyanate component is used, the polyamideimide resin can be obtained in one step by reaction with the above acid component.

Other than requiring the use of at least compounds represented by formula (I) and formula (II) shown below as the diamine component or diisocyanate component, the polyamideimide resin disclosed in the present description may be produced without any particular limitations. In other words, in one embodiment, the polyamideimide resin includes a resin formed using at least compounds represented by formula (I) and formula (II) shown below, and an acid component containing a tricarboxylic acid anhydride.

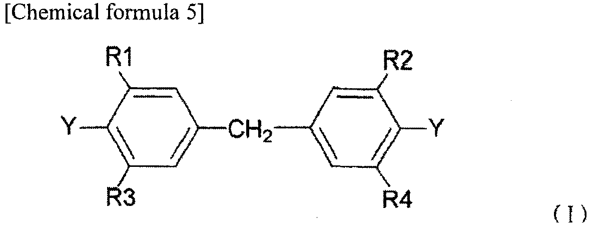

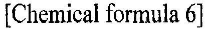

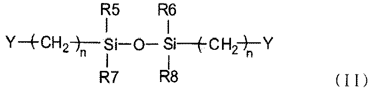

In formula (I), each of R1 to R4 independently represents an alkyl group of 3 to 9 carbon atoms having a branched structure. In formula (II), each of R5 to R8 independently represents an alkyl group of 1 to 3 carbon atoms, wherein the alkyl group may have a linear structure, a branched structure, or a cyclic structure.

Each Y independently represents an amino group (-NH₂) or an isocyanate group (-NCO).

Further, n represents an integer of 1 to 6.

Further, n is more preferably an integer of 2 to 5, and even more preferably 3 or 4. In one embodiment, a combination of a diamine and a diisocyanate may be used for each of the compounds represented by formula (I) and (II).

If the substituents on the aromatic rings are bulky, then steric hindrance becomes more likely, and therefore the Tg value tends to increase. Accordingly, in the present invention, from the viewpoint of the heat resistance, each of R1 to R4 in formula (I) independently represents an alkyl group of 3 to 9 carbon atoms having a branched structure. On the other hand, from the viewpoint of ease of availability of the compounds, in formula (II), each of R5 to R8 independently represents an alkyl group of 1 to 3 carbon atoms.

In one embodiment, the polyamideimide resin is preferably formed using at least compounds represented by formula (I) and formula (II) shown above. In this embodiment, the polyamideimide resin contains a structural unit (Ia) derived from the compound represented by formula (I) and a structural unit (IIa) derived from the compound represented by formula (II). The structural unit (Ia) and the structural unit (IIa) correspond with the residues obtained upon removal of an amino group or isocyanate group from the compounds represented by the above formula (I) and formula (II) respectively. In the formulas, R1 to R8 and n are as described above, and * denotes a bonding site with an amide linkage or imide linkage.

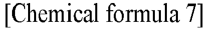

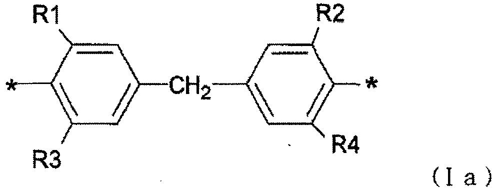

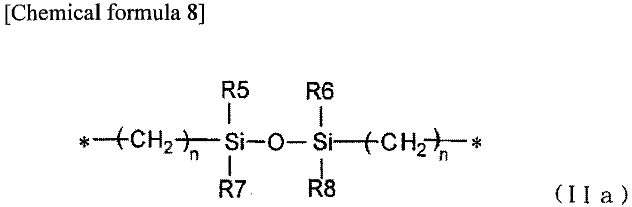

In the polyamideimide resin, it is thought that the structural unit (Ia) contributes to raising the Tg value, whereas the structural unit (IIa) contributes to improving the flexibility. Accordingly, it is surmised that by including both of these structural units within the molecule, a favorable balance between heat resistance and flexibility can be achieved.

In one embodiment, the structural unit (Ia) is preferably a structural unit (I-1a) derived from a diamine compound represented by formula (I-1) shown below.

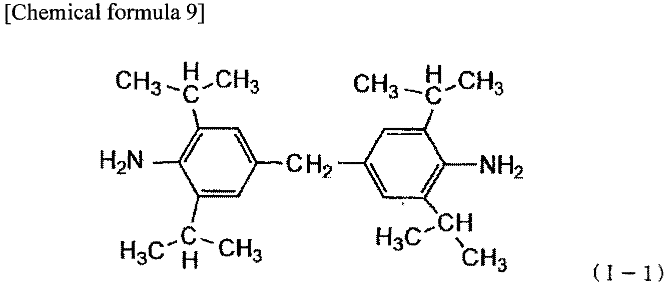

Further, in one embodiment, the structural unit (IIa) is preferably a structural unit (II-1a) derived from a diamine compound represented by formula (11-1) shown below.

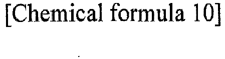

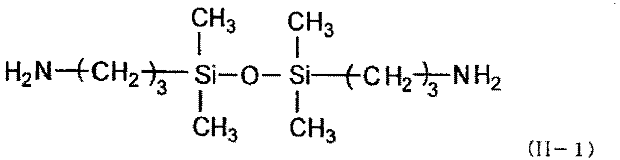

An additional diamine component or diisocyanate component other than the compounds represented by the above formula (I) and formula (II) may also be used in forming the polyamideimide resin.

The above diamine component is a primary amine having two amino groups (-NH₂) within the molecule, and may be any one of an aromatic diamine, an aliphatic diamine and an alicyclic diamine. The diamine component is preferably an aromatic diamine having two or more aromatic rings within the molecule.

Further, the above diisocyanate component is a compound having two isocyanate groups (-NCO) within the molecule, and may be any one of an aromatic diisocyanate, an aliphatic diisocyanate and an alicyclic diisocyanate. The diisocyanate component is preferably an aromatic diisocyanate having two or more aromatic rings within the molecule.

In one embodiment, the polyamideimide resin preferably also contains a structural unit (IIIa) derived from a compound represented by formula (III) shown below.

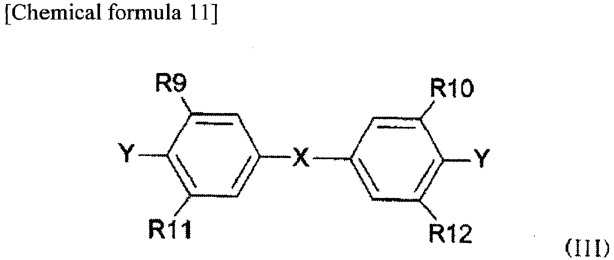

In formula (III), X represents a linking group selected from the group consisting of -O-, -S-, - SO₂-, -C(=O)- and -S(=O)-. In one embodiment, X is preferably -O-.

Each of R9 to R12 independently represents a hydrogen atom, or at least one substituent selected from the group consisting of alkyl groups of 1 to 9 carbon atoms, alkoxy groups of 1 to 9 carbon atoms and halogen atoms. The alkyl groups and alkoxy groups may have a linear structure, a branched structure, or a cyclic structure. The halogen atoms may be a fluorine atom, a chlorine atom or a bromine atom. In one embodiment, each of R9 to R12 preferably represents a hydrogen atom.

Each Y independently represents an amino group or an isocyanate group. In one embodiment, a combination of a diamine and a diisocyanate may be used as the compound represented by formula (III).

The structural unit (IIIa) represented by the formula below corresponds with a residue obtained upon removal of an amino group or isocyanate group from the compound represented by the above formula (III). In the formulas, R9 to R12 and X are as described above, and * denotes a bonding site with an amide linkage or imide linkage.

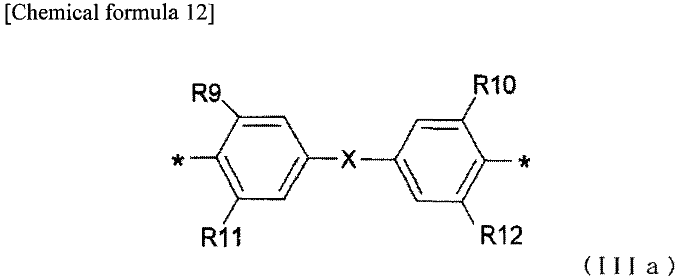

In one embodiment, the structural unit (IIIa) is preferably a structural unit (III-1a) derived from a diamine compound represented by formula (III-1) shown below.

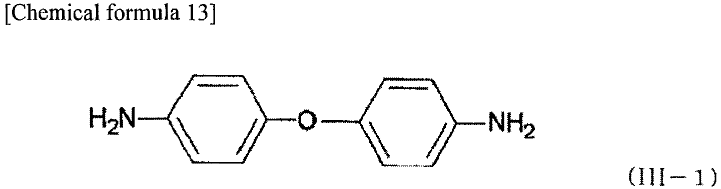

In the polyamideimide resin described above, the proportion of the structural unit (Ia) derived from a compound represented by formula (I), relative to the total of all of the structural units derived from diamine components and/or diisocyanate components, is preferably within a range from 40 to 50 mol%, more preferably from 42 to 50 mol%, and even more preferably from 42 to 48 mol%. The proportion of the structural unit (IIa) derived from a compound represented by formula (II), relative to the total of all of the structural units derived from diamine components and/or diisocyanate components, is preferably within a range from 5 to 15 mol%, more preferably from 8 to 15 mol%, and even more preferably from 8 to 12 mol%. In the polyamideimide resin, the combined proportions of the structural unit (Ia) and the structural unit (IIa) is preferably at least 48 mol%, more preferably at least 50 mol%, and even more preferably 53 mol% or greater. In one embodiment, the above combined proportions may represent 100 mol%. In this description, a proportion (mol%) of a structural unit is calculated from the number of moles of compound in the amount added of the monomer compound corresponding with the structural unit.

In another embodiment, from the viewpoint of facilitating an increase in the Tg value and an improvement in the flexibility, the polyamideimide resin may also contain the structural unit (IIIa). In one embodiment, the proportion of the structural unit (IIIa), relative to the total of all of the structural units derived from diamine components and/or diisocyanate components, is preferably not more than 52 mol%, more preferably not more than 50 mol%, and even more preferably 47 mol% or less (but not zero). Although there are no particular limitations, the proportion of the structural unit (IIIa), relative to the total of all of the structural units derived from diamine components and/or diisocyanate components, is preferably at least 10 mol%, more preferably at least 15 mol%, and even more preferably 18 mol% or greater. In one embodiment, the combined proportions of the above structural units (Ia), (IIa) and (IIIa) may represent 100 mol%.

In yet another embodiment, the polyamideimide resin may also contain, in addition to the above structural units (Ia), (IIa) and the optional (IIIa), another structural unit derived from a different aromatic diamine or aromatic diisocyanate, aliphatic diamine or aliphatic diisocyanate, or alicyclic diamine or alicyclic diisocyanate. The proportion of this type of structural unit, relative to the total of all of the structural units derived from diamine components and/or diisocyanate components, is preferably not more than 20 mol%. Examples of the aromatic diamine (or diisocyanate) include naphthalenediamine and naphthalene diisocyanate. Examples of the aliphatic diamine (or diisocyanate) include hexamethylenediamine and hexamethylene diisocyanate. Examples of the alicyclic diamine (or diisocyanate) include 4,4'-dicyclohexylmethanediamine and 4,4'-dicyclohexylmethane diisocyanate.

The acid component used in forming the polyamideimide resin contains at least a tricarboxylic acid anhydride or an acid halide thereof. The tricarboxylic acid anhydride may be a derivative of an aromatic compound, aliphatic compound or alicyclic compound having three or more carboxyl groups in the molecule. Examples of the tricarboxylic acid anhydride include trimellitic anhydride and cyclohexane tricarboxylic anhydride.

Among the various tricarboxylic acid anhydrides, from the viewpoints of cost, reactivity, and solubility and the like, trimellitic anhydride is preferred. Acid halides of trimellitic anhydride are also preferred. A single tricarboxylic acid anhydride or acid halide thereof may be used alone, or a combination of two or more such compounds may be used.

In one embodiment, the polyamideimide resin is preferably formed using trimellitic anhydride or an acid halide thereof, represented by formula (IV) shown below, as the acid component.

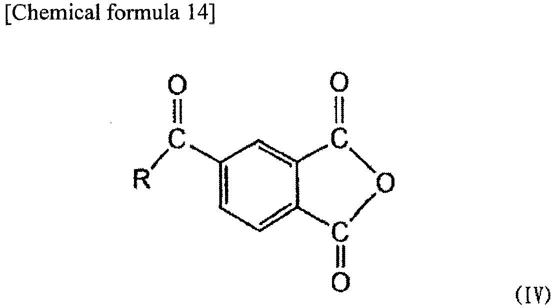

In the formula, R represents a hydroxyl group or a halogen atom. The halogen atom is preferably a chlorine atom or a bromine atom, and is more preferably a chlorine atom.

In one embodiment, in those cases where a diamine is used, the use of an acid halide of trimellitic anhydride as the acid component is preferred, and the use of trimellitic anhydride chloride represented by formula (IV-1) shown below is particularly desirable.

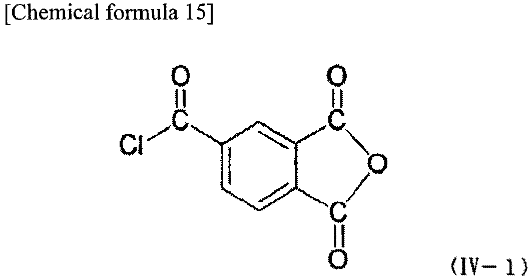

From the viewpoints mentioned above, in one embodiment, the polyamideimide resin preferably contains a structural unit (IVa) derived from a compound represented by the above formula (IV).

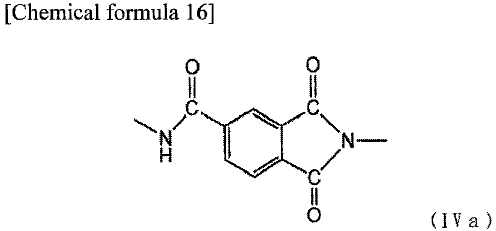

The acid component may also contain another additional acid component in addition to the tricarboxylic acid anhydride or acid halide thereof described above. For example, a tricarboxylic acid such a trimellitic acid may be included as this other acid component. Further, the acid component may also contain tetracarboxylic acid dianhydrides such as pyromellitic anhydride and biphenyltetracarboxylic dianhydride, aromatic dicarboxylic acids such as terephthalic acid and isophthalic acid, alicyclic dicarboxylic acids such as cyclohexanedicarboxylic acid, and aliphatic dicarboxylic acids such as adipic acid and sebacic acid and the like.

In one embodiment, the polyamideimide resin contains a structural unit (1A) and/or (1B) shown below, and a structural unit (2A) and/or (2B) shown below. This type of polyamideimide resin can be obtained, for example, via a reaction between trimellitic anhydride or an acid halide thereof, and two compounds represented by formula (I) and formula (II) respectively. In each of the formulas, R1 to R8 are the same as described above for formulas (I) and (II).

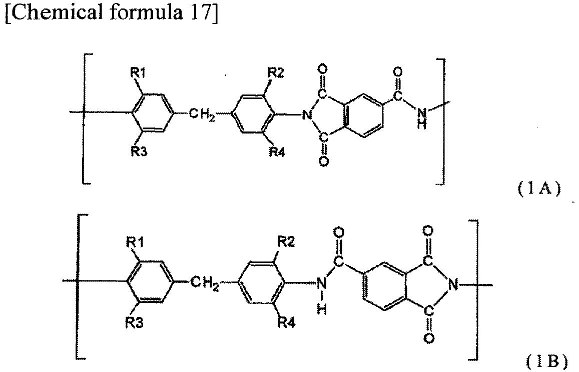

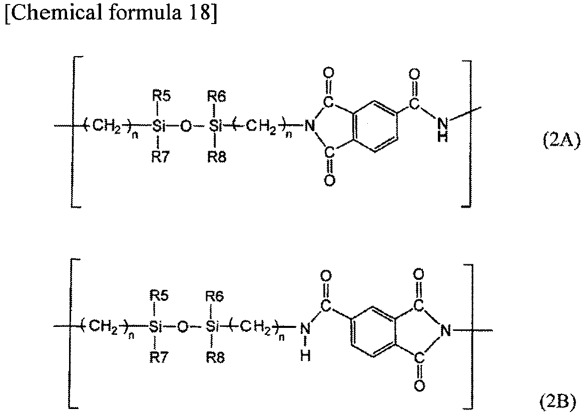

The polyamideimide resin of the embodiment described above more preferably contains a structure (1A-1) and/or (1B-1) shown below, and a structure (2A-1) and/or (2B-1) shown below.

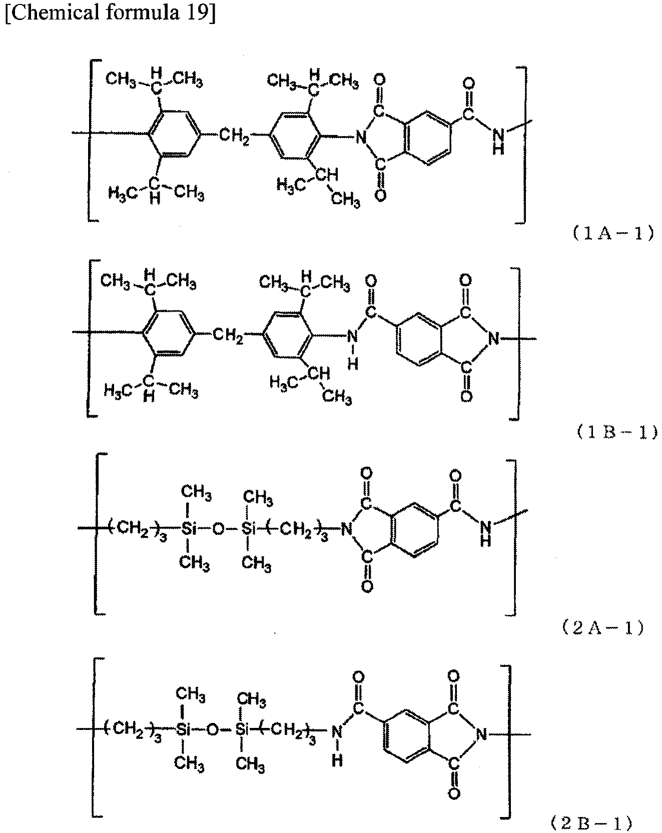

In another embodiment, the polyamideimide resin preferably also contains, in addition to the structures represented by the above formulas (1A) to (2B), a structure represented by formula (3A) and/or (3B) shown below. In the formula below, X is the same as described above for X in formula (III). This type of polyamideimide resin can be obtained, for example, via a reaction between trimellitic anhydride or an acid halide thereof, and three compounds represented by formulas (I), (II) and (III) respectively.

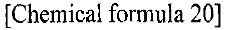

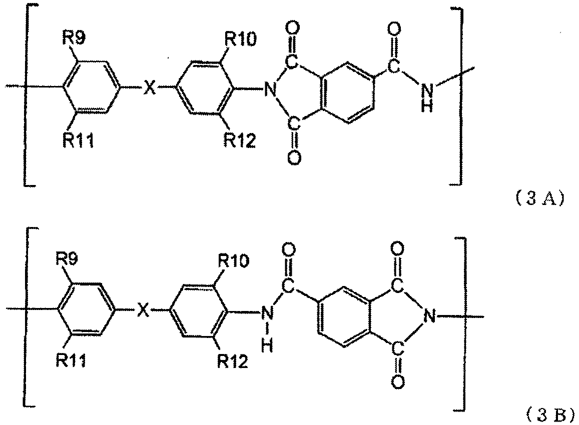

The polyamideimide resin of the embodiment described above more preferably contains, in addition to the structures represented by the above formulas (1A) to (2B), a structure (3A-1) and/or (3B-1) shown below.

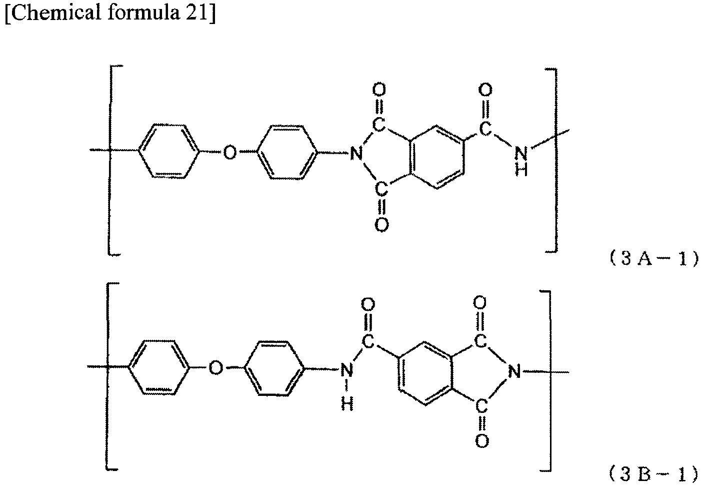

The polyamideimide resin of the embodiment described above preferably has a glass transition temperature of 250°C or higher. In this description, the "glass transition temperature (Tg)" is a value obtained by conducting a dynamic viscoelasticity test using a film obtained by applying and then drying a solution of the polyamideimide resin that has been dissolved in a solvent. In a preferred embodiment, the polyamideimide resin has a Tg value of 270°C or higher. By ensuring that the polyamideimide resin has a Tg value of 250°C or higher, excellent reliability can be achieved even in heat cycling tests that are typically conducted under high temperatures of 250°C or higher. Further, when a power semiconductor device is produced using the polyamideimide resin, any softening of the resin and deterioration in the adhesion due to heat generation during operation of the device can be suppressed.

In one embodiment, the polyamideimide resin is preferably soluble in a solvent at room temperature. In this description, the expression "soluble in a solvent at room temperature" means that when a solution is prepared by adding and mixing a powder of the polyamideimide resin with a solvent standing at room temperature, without requiring any restriction or adjustment of the temperature of the solvent, and the solution is then inspected visually, no sedimentation or turbidity is visible, with the entire solution existing in a transparent state.

Here, "room temperature" means a temperature within a range from 10°C to 40°C. Further, the term "solution" means a solution obtained by adding 1 to 30 mg of a powder of the polyamideimide resin to 100 mL of the solvent. Although not a particular limitation, the polyamideimide resin is preferably soluble in a solvent at a temperature within a range from 10°C to 40°C, and is more preferably in a solvent at a temperature within a range from 20°C to 30°C. The solvent is described below.

The weight average molecular weight (Mw) of the polyamideimide resin is preferably within a range from 45,000 to 120,000. A polyamideimide resin having a Mw value within this range can more readily form a coating film of the preferred thickness described below during a coating operation. The Mw value of the polyamideimide resin is more preferably within a range from 50,000 to 110,000, and even more preferably within a range from 60,000 to 100,000. In this description, "Mw" values represent values measured relative to standard polystyrenes using gel permeation chromatography.

### (Method for Producing Polyamideimide Resin)

The polyamideimide resin can be produced by conventional methods, and there are no particular limitations. For example, the polyamideimide resin can be produced via reaction between a diamine component and/or a diisocyanate component, and an acid component. The diamine component, the diisocyanate component and the acid component are as described above. The reaction may be performed in a solventless state or in the presence of an organic solvent. The reaction temperature is preferably within a range from 25°C to 250°C. The reaction time may be set as appropriate in accordance with factors such as the batch scale and the reaction conditions being employed.

There are no particular limitations on the organic solvent (reaction solvent) used during production of the polyamideimide resin. Examples of organic solvents that may be used include ether-based solvents such as diethylene glycol dimethyl ether, diethylene glycol diethyl ether, triethylene glycol dimethyl ether and triethylene glycol diethyl ether, sulfur-containing solvents such as dimethylsulfoxide, diethylsulfoxide, dimethylsulfone and sulfolane, cyclic ester-based (lactone-based) solvents such as γ-butyrolactone, acyclic ester-based solvents such as cellosolve acetate, ketone-based solvents such as cyclohexanone and methyl ethyl ketone, nitrogen-containing solvents such as N-methyl-2-pyrrolidone, dimethylacetamide and 1,3-dimethyl-3,4,5,6-tetrahydro-2(1H)-pyrimidinone, and aromatic hydrocarbon-based solvents such as toluene and xylene. One of these organic solvents may be used alone, or a combination of two or more organic solvents may be used.

In one embodiment, an organic solvent that is capable of dissolving the produced resin is preferably selected and used, and the use of a polar solvent is preferred. Details regarding polar solvents are described below, but nitrogen-containing solvents are preferred.

In one embodiment, the polyamideimide resin can be produced by a method in which a precursor to the polyamideimide resin is first produced by a reaction between an acid component and a diamine component, and this precursor is then subjected to a dehydration cyclization to obtain the polyamideimide resin. However, there are no particular limitations on the precursor cyclization method, and any method that is known in the technical field may be used. For example, a heat cyclization method in which the dehydration cyclization is achieved by conducting heating either at normal pressure or under reduced pressure, or a chemical cyclization method that uses a dehydration agent such as acetic anhydride, either in the presence of a catalyst or without a catalyst, may be used.

In the case of a heat cyclization method, the cyclization is preferably performed while the water produced by the dehydration reaction is removed from the system. During the dehydration reaction, the reaction liquid may be heated to a temperature within a range from 80°C to 400°C, and preferably from 100°C to 250°C. Further, the water may also be removed by azeotropic distillation by using an organic solvent capable of forming an azeotrope with water, such as benzene, toluene and xylene.

In the case of a chemical cyclization method, the reaction may be performed in the presence of a chemical dehydration agent at a temperature of 0°C to 120°C, and preferably 10°C to 80°C. Examples of chemical dehydration agents that can be used favorably include acid anhydrides such as acetic anhydride, propionic anhydride, butyric anhydride and benzoic anhydride, and carbodiimide compounds such as dicyclohexylcarbodiimide. During the reaction, a material that accelerates the cyclization reaction such as pyridine, isoquinoline, trimethylamine, triethylamine, aminopyridine or imidazole is also preferably used in combination with the chemical dehydration agent. The chemical dehydration agent may be used in a ratio of 90 to 600 mol% relative to the total amount of the diamine component, and the material that accelerates the cyclization reaction may be used in a ratio of 40 to 300 mol% relative to the total amount of the diamine component. Further, a dehydration catalyst, including phosphorus compounds such as triphenyl phosphite, tricyclohexyl phosphite, triphenyl phosphate, phosphoric acid and phosphorus pentoxide, and boron compounds such as boric acid and boric anhydride, may also be used.

In the production of the polyamideimide resin, the usage ratio (molar ratio) between the acid component and the diamine component (diisocyanate component) is not particularly limited, and may be adjusted to ensure that the reaction proceeds with neither excess nor deficiency. In one embodiment, from the viewpoint of the molecular weight and the degree of crosslinking of the produced polyamideimide resin, the total amount of the diamine component per 1.00 mol of the total acid component is preferably within a range from 0.80 to 1.10 mol, more preferably from 0.95 to 1.08 mol, and even more preferably from 0.95 to 1.03 mol.

### <Polyamideimide Resin Composition>

In one embodiment, a polyamideimide resin composition may be a varnish containing the polyamideimide resin of an embodiment described above, and a solvent capable of dissolving the polyamideimide resin.

### (Solvent)

There are no particular limitations on the solvent, provided it is capable of dissolving the polyamideimide resin, but an organic solvent is preferred. In this description, the expression "solvent capable of dissolving the polyamideimide resin" means that when a solution is prepared by adding and mixing a powder of the polyamideimide resin with the solvent, without any particular restriction of the temperature of the solvent, and the solution is then inspected visually, no sedimentation or turbidity is visible, with the entire solution existing in a transparent state. The term "solution" means a solution obtained by adding 1 to 30 mg of a powder of the polyamideimide resin to 100 mL of the solvent. Although not a particular limitation, the temperature of the solvent in the solution is preferably within a range from 10°C to 40°C, and more preferably within a range from 20°C to 30°C. In other words, in one embodiment, the solvent is preferably capable of dissolving the polyamideimide resin at room temperature. In one embodiment, the solvent that constitutes the resin composition may be the same solvent as the reaction solvent used during production of the resin. In one embodiment, from the viewpoint of more easily achieving superior solubility, a polar solvent is preferred.

Examples of polar solvents include nitrogen-containing compounds such as N-methylpyrrolidone, dimethylacetamide, dimethylformamide and 1,3-dimethyltetrahydro-2(1H)-pyrimidinone, sulfur-containing compounds such as sulfolane and dimethylsulfoxide, lactones such as γ-butyrolactone, γ-valerolactone, γ-caprolactone, γ-heptalactone, α-acetyl-γ-butyrolactone and ε-caprolactone, ketones such as methyl ethyl ketone, methyl isobutyl ketone, cyclohexanone and acetophenone, acyclic esters such as cellosolve acetate, and ethers including ethylene glycol, glycerol, diethylene glycol dialkyl ethers such as diethylene glycol dimethyl ether, diethylene glycol diethyl ether, diethylene glycol dipropyl ether and diethylene glycol dibutyl ether, triethylene glycol dialkyl ethers such as triethylene glycol dimethyl ether, triethylene glycol diethyl ether, triethylene glycol dipropyl ether and triethylene glycol dibutyl ether, tetraethylene glycol dialkyl ethers such as tetraethylene glycol dimethyl ether, tetraethylene glycol diethyl ether, tetraethylene glycol dipropyl ether and tetraethylene glycol dibutyl ether, diethylene glycol monoalkyl ethers such as diethylene glycol monomethyl ether and diethylene glycol monoethyl ether, triethylene glycol monoalkyl ethers such as triethylene glycol monomethyl ether and triethylene glycol monoethyl ether, and tetraethylene glycol monoalkyl ethers such as tetraethylene glycol monomethyl ether and tetraethylene glycol monoethyl ether.

One of these solvents may be used alone, or a combination of two or more solvents may be used. In one embodiment, the solvent is preferably a nitrogen-containing solvent, and among such solvents, N-methylpyrrolidone is particularly preferred. In another embodiment, the solvent is preferably an ether, and among such solvents, diethylene glycol dialkyl ethers are particularly preferred.

The blend amount of the solvent in the polyamideimide resin composition may be adjusted appropriately with due consideration of the storage elastic modulus or the viscosity. Although not a particular limitation, in one embodiment, the blend amount of the solvent is preferably within a range from 100 to 3,500 parts by weight per 100 parts by weight of the total amount of polyamideimide resin in the polyamideimide resin composition. A polar solvent is more preferably added in a ratio within a range from 150 to 1,000 parts by weight per 100 parts by weight of the total amount of polyamideimide resin.

### (Additives)

If required, additives such as colorants and coupling agents, and additional components such as resin modifiers may be added to the above polyamideimide resin composition (varnish). In those cases where the polyamideimide resin composition contains additional components, the blend amount of those additional components is preferably not more than 50 parts by weight per 100 parts by weight of the total weight of polyamideimide resin (solid fraction) in the resin composition. By ensuring that the blend amount of these additional components is not more than 50 parts by weight, any deterioration in the physical properties of the obtained coating film can be more easily suppressed.

In one embodiment, the polyamideimide resin composition may contain a coupling agent. Examples of additional components that may be used are described below.

### (Coupling Agents)

There are no particular limitations on the types of coupling agents that may be used, and examples include silane-based, titanium-based and aluminum-based coupling agents, but silane-based coupling agents are the most preferred.

There are no particular limitations on the silane-based coupling agents, and examples include vinyltrichlorosilane, vinyltris(β-methoxyethoxy)silane, vinyltriethoxysilane, vinyltrimethoxysilane, γ-methacryloxypropyltrimethoxysilane, γ-methacryloxypropylmethyldimethoxysilane, β-(3,4-epoxycyclohexyl)ethyltrimethoxysilane, γ-glycidoxypropyltrimethoxysilane, γ-glycidoxypropylmethyldimethoxysilane, γ-glycidoxypropylmethyldiethoxysilane, N-β-(aminoethyl)-γ-aminopropyltrimethoxysilane, N-β-(aminoethyl)-γ-aminopropylmethyldimethoxysilane, γ-aminopropyltriethoxysilane, N-phenyl-γ-aminopropyltrimethoxysilane, γ-mercaptopropyltrimethoxysilane, γ-mercaptopropyltriethoxysilane, 3-aminopropylmethyldiethoxysilane, 3-ureidopropyltriethoxysilane, 3-ureidopropyltrimethoxysilane, 3-aminopropyltrimethoxysilane, 3-aminopropyl-tris[2-(2-methoxyethoxy)ethoxy]silane, N-methyl-3-aminopropyltrimethoxysilane, triaminopropyltrimethoxysilane, 3-4,5-dihydroimidazol-1-yl-propyltrimethoxysilane, 3-methacryloxypropyltrimethoxysilane, 3-mercaptopropylmethyldimethoxysilane, 3-chloropropylmethyldimethoxysilane, 3-chloropropyldimethoxysilane, 3-cyanopropyltriethoxysilane, hexamethyldisilazane, N,O-bis(trimethylsilyl)acetamide, methyltrimethoxysilane, methyltriethoxysilane, ethyltrichlorosilane, n-propyltrimethoxysilane, isobutyltrimethoxysilane, amyltrichlorosilane, octyltriethoxysilane, phenyltrimethoxysilane, phenyltriethoxysilane, methyltri(methacryloyloxyethoxy)silane, methyltri(glycidyloxy)silane, N-β-(N-vinylbenzylaminoethyl)-γ-aminopropyltrimethoxysilane, octadecyl dimethyl- [3-(trimethoxysilyl)propyl]ammonium chloride, γ-chloropropylmethyldichlorosilane, γ-chloropropylmethyldimethoxysilane, γ-chloropropylmethyldiethoxysilane, trimethylsilyl isocyanate, dimethylsilyl isocyanate, methylsilyl triisocyanate, vinylsilyl triisocyanate, phenylsilyl triisocyanate, tetraisocyanatosilane, and ethoxysilane isocyanate. One of these silane-based coupling agents may be used alone, or a combination of two or more silane-based coupling agents may be used.

There are no particular limitations on the titanium-based coupling agents, and examples include isopropyltrioctanoyl titanate, isopropyldimethacrylisostearoyl titanate, isopropyltridodecylbenzenesulfonyl titanate, isopropylisostearoyldiacryl titanate, isopropyltri(dioctyl phosphate) titanate, isopropyltricumylphenyl titanate, isopropyltris(dioctyl pyrophosphate) titanate, isopropyltris(n-aminoethyl) titanate, tetraisopropylbis(dioctyl phosphite) titanate, tetraoctylbis(ditridecyl phosphite) titanate, tetra(2,2-diallyloxymethyl-1-butyl)-bis(ditridecyl) phosphite titanate, dicumylphenyloxyacetate titanate, bis(dioctyl pyrophosphate)oxyacetate titanate, tetraisopropyl titanate, tetra-normal-butyl titanate, butyl titanate dimer, tetra(2-ethylhexyl) titanate, titanium acetylacetonate, polytitanium acetylacetonate, titanium octylene glycolate, ammonium titanium lactate, titanium lactate, titanium lactate ethyl ester, titanium triethanolaminate, polyhydroxytitanium stearate, tetramethyl orthotitanate, tetraethyl orthotitanate, tetrapropyl orthotitanate, tetraisobutyl orthotitanate, stearyl titanate, cresyl titanate monomer, cresyl titanate polymer, diisopropoxy-bis(2,4-pentadionate) titanium(IV), diisopropyl-bis-triethanolaminotitanate, octylene glycol titanate, tetra-n-butoxytitanium polymer, tri-n-butoxytitanium monostearate polymer, and tri-n-butoxytitanium monostearate. One of these titanium-based coupling agents may be used alone, or a combination of two or more titanium-based coupling agents may be used.

There are no particular limitations on the aluminum-based coupling agents, and examples include aluminum chelate compounds such as ethylacetoacetatoaluminum diisopropylate, aluminum tris(ethylacetoacetate), alkylacetoacetatoaluminum diisopropylate, aluminum monoacetylacetoacetate bis(ethylacetoacetate), aluminum tris(acetylacetonate), aluminum monoisopropoxymonooleoxyethyl acetoacetate, aluminum di-n-butoxide monoethylacetoacetate, and aluminum diisopropoxide monoethylacetoacetate, and aluminum alcoholates such as aluminum isopropylate, mono-sec-butoxyaluminum diisopropylate, aluminum sec-butylate and aluminum ethylate. One of these aluminum-based coupling agents may be used alone, or a combination of two or more aluminum-based coupling agents may be used.

### (Colorants)

In one embodiment, the polyamideimide resin composition may contain a colorant. Examples of the colorant include carbon black, dyes, and pigments and the like. A pigment is preferably used as the colorant. In those cases where the polyamideimide resin composition contains a colorant, a colored film can be obtained, and therefore whether or not a film has been formed can be determined visually more easily. Although not a particular limitation, when a pigment composed of a white-colored powder is used, a white film is obtained, which is preferred in terms of making visual determination of film formation even easier. The white-colored powdered pigment may be titanium oxide or alumina or the like.

The particle size of the pigment may be adjusted as appropriate provided the coating film characteristics are not impaired. In one embodiment, the average particle size (average primary particle size) of the pigment is preferably less than 100 µm, more preferably less than 50 µm, and even more preferably less than 20 µm. When the average particle size of the pigment falls within this range, a coating film of uniform thickness and color can be more easily obtained upon film formation. The average particle size of the pigment is a value measured using a laser diffraction particle size distribution measurement device.

In one embodiment, the viscosity of the polyamideimide resin composition is preferably within a range from 10 to 400 mPa·s, and more preferably within a range from 10 to 300 mPa·s. Here, the "viscosity" is a value obtained by measuring a varnish, obtained by dissolving the resin in the solvent to achieve a non-volatile fraction (solid fraction component) of 1 to 20%, using an E-type viscometer at 25°C and 10 rpm. Provided the viscosity measured at 10 rpm is at least 10 mPa·s, a satisfactory film thickness can be more easily ensured during coating. Further, provided the viscosity is not more than 400 mPa·s, uniform film thickness can be more easily ensured during coating. Accordingly, by adjusting the viscosity to a value within the above range, superior printability can be more easily achieved. In one embodiment, from the viewpoint of achieving excellent printability, the viscosity preferably exceeds 160 mPa·s, more preferably exceeds 180 mPa·s, and even more preferably exceeds 200 mPa s.

Measurement of the above viscosity may be performed, for example, using a viscometer (RE type) manufactured by Toki Sangyo Co., Ltd. During the measurement, the measurement temperature is set to 25°C±0.5°C, 1 mL to 1.5 mL of the solution of the resin composition is then inserted in the viscometer, and the viscosity is recorded 10 minutes after commencing measurement.

In one embodiment, the film thickness obtained upon film formation using the polyamideimide resin or the polyamideimide resin composition is not particularly limited, and may be within a range from 0.5 to 10 µm. By ensuring that the film has a thickness within this range, satisfactory adhesive strength tends to be more easily achieved. From this viewpoint, the film thickness is preferably within a range from 1 to 10 µm, and more preferably within a range from 3 to 10 µm.

In a semiconductor device, the adhesion between the various members, such as between the sealing resin member and the substrate or the semiconductor element, can be evaluated using the shear strength. In one embodiment, from the viewpoint of achieving superior adhesion in uses within power semiconductor devices, the polyamideimide resin composition has a shear strength at 250°C that is preferably at least 10 MPa, more preferably at least 15 MPa, and even more preferably 20 MPa or greater.

The shear strength mentioned above describes a value measured using a laminate as a sample, the laminate being prepared by applying the polyamideimide resin composition (varnish) to a substrate, drying the composition to form a film, and then molding a resin sealing member on top of the film. The shear strength can be measured, for example, using a shear strength measurement device (such as the 4000-series manufactured by Nordson Advanced Technology Corporation). The measurement is performed, for example, using a sample obtained by applying the resin composition to a Ni substrate and drying the composition to form a film, and then molding a sealing resin member of ø5 mm on top of the film using an epoxy-based sealing resin. The conditions during measurement typically include a heat stage temperature of 250°C and a probe speed of 5 mm/min. The material for the substrate and the resin sealing member may also be altered as appropriate. For example, in the measurement, a Cu substrate may be used instead of the Ni substrate, or a substrate having Ag plating on a Cu substrate may be used. However, when a Cu substrate is used, treatments to prevent oxidation of the Cu, such as conducting the drying under a N₂ atmosphere, are required.

In one embodiment, the elastic modulus at 35°C of a film obtained by applying and drying the polyamideimide resin composition (varnish) is preferably within a range from 0.5 to 3.0 GPa, and more preferably within a range from 1.0 to 3.0 GPa. This elastic modulus is a value measured using a dynamic viscoelasticity measurement device. If the elastic modulus is less than 0.5 GPa, then the film becomes too soft, and there is possibility that the reliability of power semiconductor devices may deteriorate. On the other hand, if the elastic modulus exceeds 3.0 GPa, then the stress relaxation properties of the film tend to deteriorate, which may cause a deterioration in the reliability of power semiconductor devices. From the viewpoint of obtaining favorable flexibility to further enhance the reliability of power semiconductor devices, the elastic modulus is more preferably within a range from 2.2 GPa to 3.0 GPA, and is most preferably within a range from 2.5 GPa to 3.0 GPa.

The elastic modulus can be measured, for example, using a dynamic viscoelasticity measurement device "Rheogel-E4000" manufactured by UBM Co., Ltd. A sample is prepared by cutting a film obtained by applying and drying the polyamideimide resin composition (varnish) to a width of 4 mm, and the elastic modulus is then measured using this sample, under measurement conditions including a chuck separation of 20 mm, a measurement frequency of 10 MHz, and a measurement temperature of 35°C.

### <Semiconductor Device>

The polyamideimide resin of the embodiments described above and the resin composition using those resins (hereafter jointly referred to as the "resin composition") exhibits excellent heat resistance, flexibility and printability, and can therefore be used favorably as a structural material for semiconductor devices. For example, using the resin composition described above, an insulating layer, adhesive layer, or protective layer or the like in a semiconductor device can be formed, and a semiconductor device having these types of layers exhibits excellent adhesion between the various members and superior reliability. In one embodiment, the resin composition described above can be used favorably as a structural material of a power semiconductor device that uses a silicon carbide (SiC) substrate or a gallium nitride (GaN) substrate. When a power semiconductor device is formed using the above resin composition, any deterioration in the adhesive strength between the various members during heat cycle testing can be more easily suppressed.

In one embodiment, the semiconductor device has a substrate, a semiconductor element mounted on top of the substrate, a primer layer provided on the semiconductor element-mounting surface of the substrate, and a resin sealing member provided on top of the primer layer, wherein the primer layer is formed using resin composition of an embodiment described above. In a representative structure for the semiconductor device, the substrate may be a lead frame composed of a die pad for mounting the semiconductor element and leads, wherein the electrode pads of the semiconductor element and the leads of the lead frame are connected electrically via wires. A semiconductor device having this type of structure is illustrated in FIG. 1.

FIG. 1 is a schematic cross-sectional view illustrating an embodiment of a semiconductor device. The semiconductor device illustrated in FIG. 1 has a die pad 1a, a semiconductor element 2, a primer layer 3, leads 1b, wires 4, and a resin sealing member 5, wherein the prime layer 3 is formed from the polyamideimide resin composition of an embodiment described above. As illustrated in FIG. 1, by providing the primer layer 3 formed from the resin composition described above on the semiconductor element-mounting surface of the substrate 1 that contacts the resin sealing member 5 (and the surfaces of the leads 1b and the die pad 1a on which the semiconductor element 2 is mounted), the adhesion between the various members can be enhanced.

In one embodiment, a method for producing a semiconductor device includes at least a step of forming a prime layer by applying the polyamideimide resin composition to the surface of a substrate on which a semiconductor element has been mounted and then drying the composition, and a step of forming a resin sealing member on top of the primer layer.

In this embodiment, the primer layer is formed using a polyamideimide resin or polyamideimide resin composition. From the viewpoint of workability, a polyamideimide resin composition is preferably used. The primer layer can be obtained by applying the polyamideimide resin composition described above to the prescribed location, and then drying the coating film. There are no particular limitations on the method used for applying the polyamideimide resin composition, and examples include spray coating methods, potting methods, dipping methods, spin coating methods, and dispensing methods and the like. From the viewpoint of workability and the like, a dipping method, dispensing coating method or spin coating method is preferred.

There are no particular limitations on the materials for the lead frame composed of the die pad used for mounting the semiconductor element and the leads, and conventional materials known in the technical field may be selected. From the viewpoint of application to power semiconductor devices, the die pad material preferably contains at least one material selected from the group consisting of Ni and Cu. Further, a material prepared by forming Ag plating on the surface of a material selected from the group consisting of Ni and Cu may also be used. The lead material of the lead frame is preferably selected from the group consisting of Ni and Cu.

The material of the semiconductor element is not particularly limited, and for example, may be a silicon wafer or a silicon carbide wafer or the like.

The resin sealing member may be formed using a resin material that is known in the technical field as a sealing material. For example, liquid or solid epoxy-based resin compositions may be used. The resin sealing member can be formed, for example, by conducting transfer molding using the sealing material.

In another embodiment, the method for producing the semiconductor device includes, for example, a step of applying the polyamideimide resin composition of an embodiment described above to a semiconductor substrate on which is formed a plurality of wires of the same structure and then drying the composition to form a resin layer, and, if required, a step of forming rewiring on top of the resin layer to electrically connect to the electrodes on the semiconductor substrate. Further, in addition to these steps, if required, the production method may also include a step of forming a protective layer (resin layer) on top of the rewiring or the resin layer using the polyamideimide resin composition of the above embodiment. Moreover, in addition to the above steps, if required, the production may also include a step of forming external electrode terminals on the above resin layer, and then a step of performing dicing if required.

There are no particular limitations on the coating method used for forming the above resin layer, but spin coating, spray coating, or dispensing coating is preferred. The method used for drying the resin layer may employ a method that is known in the technical field. The polyamideimide resin composition of the embodiments described above also exhibits excellent characteristics such as sputtering resistance, plating resistance and alkali resistance, which may be necessary in the step of forming the rewiring, and therefore the polyamideimide resin composition is not limited to the types of semiconductor device structures described above, and can be used favorably as a material in all manner of semiconductor devices.

### EXAMPLES

The present invention is described below in further detail using a series of examples, but the present invention is not limited to these examples.

### 1. Synthesis of Polyamideimide Resins

### (Synthesis Example 1)

A 1-liter four-neck flask fitted with a thermometer, a stirrer, a nitrogen inlet tube and a condenser fitted with an oil-water separator was charged, under a stream of nitrogen, with 49.488 g of 4,4'-methylenebis(2,6-diisopropylaniline), 27.027 g of 4,4'-diaminodiphenyl ether and 7.46 g of 1,3-bis(3-aminopropyl)-1,1,3,3-tetramethyldisiloxane, and these components were then dissolved by adding 700 g of N-methyl-2-pyrrolidone (NMP).

Subsequently, 63.80 g of trimellitic anhydride chloride (TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish (by obtaining reaction solution containing a polyamideimide resin). This polyamideimide resin varnish was poured into water, and the resulting precipitate was separated, crushed, and dried to obtain a powdered polyamideimide resin (PAI-1). Measurement of the (polystyrene-equivalent) weight average molecular weight (Mw) of the thus obtained polyamideimide resin (PAI-1) at 40°C by gel permeation chromatography (GPC) using NMP as the eluent revealed a Mw value of 88,000.

Detailed conditions for the Mw measurement were as follows.
Feed pump: LC-20AD (manufactured by Shimadzu Corporation)
UV-Vis detector: SPD-20A (manufactured by Shimadzu Corporation) Column: Shodex KD-806M (manufactured by Showa Denko K.K.)
Eluent: NMP, manufactured by Mitsubishi Chemical Corporation
Flow rate: 1 mL/min
Column temperature: 40°C
Molecular weight standards: standard polystyrenes

### (Synthesis Example 2)

A 1-liter four-neck flask fitted with a thermometer, a stirrer, a nitrogen inlet tube and a condenser fitted with an oil-water separator was charged, under a stream of nitrogen, with 49.488 g of 4,4'-methylenebis(2,6-diisopropylaniline), 27.027 g of 4,4'-diaminodiphenyl ether and 7.46 g of 1,3-bis(3-aminopropyl)-1,1,3,3-tetramethyldisiloxane, and these components were then dissolved by adding 700 g of N-methyl-2-pyrrolidone (NMP).

Subsequently, 64.80 g of trimellitic anhydride chloride (TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-2). Measurement of the polystyrene-equivalent weight average molecular weight (Mw) of the polyamideimide resin (PAI-2) using gel permeation chromatography (GPC) revealed a Mw value of 100,000.

### (Synthesis Example 3)

A 1-liter four-neck flask fitted with a thermometer, a stirrer, a nitrogen inlet tube and a condenser fitted with an oil-water separator was charged, under a stream of nitrogen, with 49.488 g of 4,4'-methylenebis(2,6-diisopropylaniline), 27.027 g of 4,4'-diaminodiphenyl ether and 7.46 g of 1,3-bis(3-aminopropyl)-1,1,3,3-tetramethyldisiloxane, and these components were then dissolved by adding 700 g of N-methyl-2-pyrrolidone (NMP).

Subsequently, 61.80 g of trimellitic anhydride chloride (TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-3). Measurement of the polystyrene-equivalent weight average molecular weight (Mw) of the polyamideimide resin (PAI-3) using gel permeation chromatography (GPC) revealed a Mw value of 65,000.

### (Synthesis Example 4)

A 1-liter four-neck flask fitted with a thermometer, a stirrer, a nitrogen inlet tube and a condenser fitted with an oil-water separator was charged, under a stream of nitrogen, with 98.977 g of 4,4'-methylenebis(2,6-diisopropylaniline) and 7.46 g of 1,3-bis(3-aminopropyl)-1,1,3,3-tetramethyldisiloxane, and these components were then dissolved by adding 700 g of N-methyl-2-pyrrolidone (NMP).

Subsequently, 61.80 g of trimellitic anhydride chloride (TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-4). Measurement of the polystyrene-equivalent weight average molecular weight (Mw) of the polyamideimide resin (PAI-4) using gel permeation chromatography (GPC) revealed a Mw value of 55,000.

### (Synthesis Example 5)

A 1-liter four-neck flask fitted with a thermometer, a stirrer, a nitrogen inlet tube and a condenser fitted with an oil-water separator was charged, under a stream of nitrogen, with 102.389 g of 2,2-bis[4-(4-aminophenoxy)phenyl]propane and 6.89 g of 1,3-bis(3-aminopropyl)-1,1,3,3-tetramethyldisiloxane, and these components were then dissolved by adding 700 g of N-methyl-2-pyrrolidone (NMP).

Subsequently, 59.00 g of trimellitic anhydride chloride (TAC) was added while the flask was cooled to ensure that the temperature of the reaction solution did not exceed 20°C. After stirring for one hour at room temperature, 33.96 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-5). Measurement of the polystyrene-equivalent weight average molecular weight (Mw) of the polyamideimide resin (PAI-5) using gel permeation chromatography (GPC) revealed a Mw value of 75,000.

### (Synthesis Example 6)

A 1-liter four-neck flask fitted with a thermometer, a stirrer, a nitrogen inlet tube and a condenser fitted with an oil-water separator was charged, under a stream of nitrogen, with 69.74 g of 2,2-bis[4-(4-aminophenoxy)phenyl]propane and 4.69 g of 1,3-bis(3-aminopropyl)-1,1,3,3-tetramethyldisiloxane, and these components were then dissolved by adding 700 g of N-methyl-2-pyrrolidone (NMP).

Subsequently, 25.49 g of trimellitic anhydride chloride (TAC) and 26.15 g of benzophenone tetracarboxylic dianhydride was added while the flask was cooled to ensure that the temperature of the reaction solution did not exceed 20°C. After stirring for one hour at room temperature, 14.42 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-6). Measurement of the polystyrene-equivalent weight average molecular weight (Mw) of the polyamideimide resin (PAI-6) using gel permeation chromatography (GPC) revealed a Mw value of 76,000.

### (Synthesis Example 7)

A 1-liter four-neck flask fitted with a thermometer, a stirrer, a nitrogen inlet tube and a condenser fitted with an oil-water separator was charged, under a stream of nitrogen, with 54.054 g of 4,4'-diaminodiphenyl ether and 7.46 g of 1,3-bis(3-aminopropyl)-1,1,3,3-tetramethyldisiloxane, and these components were then dissolved by adding 700 g of N-methyl-2-pyrrolidone (NMP).

Subsequently, 63.80 g of trimellitic anhydride chloride (hereafter abbreviated as TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-7). Measurement of the polystyrene-equivalent weight average molecular weight (Mw) of the polyamideimide resin (PAI-7) using gel permeation chromatography (GPC) revealed a Mw value of 78,000.

### (Synthesis Example 8)

A 1-liter four-neck flask fitted with a thermometer, a stirrer, a nitrogen inlet tube and a condenser fitted with an oil-water separator was charged, under a stream of nitrogen, with 54.987 g of 4,4'-methylenebis(2,6-diisopropylaniline) and 30.030 g of 4,4'-diaminodiphenyl ether, and these components were then dissolved by adding 700 g of N-methyl-2-pyrrolidone (NMP).

Subsequently, 61.80 g of trimellitic anhydride chloride (TAC) was added while the flask was cooled to ensure that the temperature of the reaction solution did not exceed 20°C. After stirring for one hour at room temperature, 36.72 g of triethylamine (TEA) was added while the flask was cooled to ensure that the temperature of the reaction solution did not exceed 20°C, and the reaction was then allowed to proceed for 3 hours at room temperature, thus producing a polyamic acid varnish.

The obtained polyamic acid varnish was then subjected to a dehydration condensation at 190°C over a period of 6 hours, thus producing a polyamideimide resin varnish. This polyamideimide resin varnish was poured into water, and the resulting precipitate was separated, crushed, and dried to obtain a powdered polyamideimide resin (PAI-8). Measurement of the polystyrene-equivalent weight average molecular weight (Mw) of the polyamideimide resin (PAI-8) using gel permeation chromatography (GPC) revealed a Mw value of 79,000.

### 2. Preparation of Polyamideimide Resin Compositions

### (Example 1)

At room temperature (25°C), a 0.5-liter four-neck flask was charged, under a stream of nitrogen, with 15 g of the polyamideimide resin (PAI-1) obtained in Synthesis Example 1 and 85 g of diethylene glycol dimethyl ether, and the mixture was stirred for 12 hours to obtain a polyamideimide resin composition (hereafter also referred to as a "varnish"). Visual inspection of the obtained polyamideimide resin composition revealed a yellow transparent solution. The polyamideimide resin composition was placed in a filtration device (KST-47 manufactured by Advantec Group), and a pressurized filtration was conducted at a pressure of 0.3 MPa, thus obtaining a polyamideimide resin composition (P-1).

### (Example 2)

With the exception of using the polyamideimide resin (PAI-2) obtained in Synthesis Example 2 as the polyamideimide resin, a polyamideimide resin composition (P-2) was prepared in the same manner as Example 1. Visual inspection of the obtained polyamideimide resin composition revealed a yellow transparent solution.

### (Example 3)

With the exception of using the polyamideimide resin (PAI-3) obtained in Synthesis Example 3 as the polyamideimide resin, a polyamideimide resin composition (P-3) was prepared in the same manner as Example 1. Visual inspection of the obtained polyamideimide resin composition revealed a yellow transparent solution.

### (Example 4)

With the exception of using the polyamideimide resin (PAI-4) obtained in Synthesis Example 4 as the polyamideimide resin, a polyamideimide resin composition (P-4) was prepared in the same manner as Example 1. Visual inspection of the obtained polyamideimide resin composition revealed a yellow transparent solution.

### (Comparative Example 1)

With the exception of using the polyamideimide resin (PAI-5) obtained in Synthesis Example 5 as the polyamideimide resin, a polyamideimide resin composition (P-5) was prepared in the same manner as Example 1.

### (Comparative Example 2)

With the exception of using the polyamideimide resin (PAI-6) obtained in Synthesis Example 6 as the polyamideimide resin, a polyamideimide resin composition (P-6) was prepared in the same manner as Example 1.

### (Comparative Example 3)

With the exception of using the polyamideimide resin (PAI-7) obtained in Synthesis Example 7 as the polyamideimide resin, a polyamideimide resin composition (P-7) was prepared in the same manner as Example 1.

### (Comparative Example 4)

With the exception of using the polyamideimide resin (PAI-8) obtained in Synthesis Example 8 as the polyamideimide resin, a polyamideimide resin composition (P-8) was prepared in the same manner as Example 1.

### 3. Evaluations of Characteristics of Polyamideimide Resin Compositions

Using each of the polyamideimide resin compositions obtained in Examples 1 to 4 and Comparative Examples 1 to 4, various characteristics were evaluated using the methods described below. The results are shown in Table 1.

### (Viscosity)

The viscosity of each of the polyamideimide resin compositions (polyamideimide resin varnishes (solutions) prepared by dissolving the resins in diethylene glycol dimethyl ether, solid fraction content: 15%) obtained in Examples 1 to 4 and Comparative Examples 1 to 4 was measured using a viscometer (RE-85L) manufactured by Toki Sangyo Co., Ltd. The measurements were performed under conditions including a sampling volume of 1.2 mL, a measurement temperature of 25°C, a cone rotational rate of 10 rpm, and a measurement time of 10 minutes.

### (Glass Transition Temperature and Elastic Modulus)

Each of the polyamideimide resin compositions (polyamideimide resin varnishes (solutions) prepared by dissolving the resins in diethylene glycol dimethyl ether, solid fraction content: 15%) obtained in Examples 1 to 4 and Comparative Examples 1 to 4 was applied to a substrate using a bar coater and then dried to obtain a film with a thickness of 10 µm. Complete drying of the film was then performed at 230°C over a period of two hours. The coating film obtained in this manner was cut to a width of 4 mm and used as a measurement sample. The measurement sample was placed in a dynamic viscoelasticity measurement device (Rheogel-E4000) manufactured by UBM Co., Ltd., and the glass transition temperature of the polyamideimide resin was measured. The measurement was performed under conditions including a chuck separation of 20 mm and a rate of temperature increase of 3°C/min, with the glass transition temperature (Tg) obtained from the position of the tan δ peak. Further, the elastic modulus was measured using a similar method, with the elastic modulus obtained by reading the value at 35°C.

### (Shear Strength)

The adhesive strength of each of the polyamideimide resin compositions (varnishes) obtained in Examples 1 to 4 and Comparative Examples 1 to 4 was measured using a 4000-series shear strength measurement device from ARCTEC, Inc. The polyamideimide resin composition was applied to a Ni substrate using a bar coater and then dried to obtain a film with a thickness of 10 µm.

Complete drying of the film was then performed at 230°C over a period of two hours. A resin sealing member prepared by molding a resin material into a shape of ø5 mm was provided on top of the obtained coating film, and the structure was then cured at 180°C over a period of 6 hours to produce a measurement sample. An epoxy-based sealing resin (CEL-420HFC) manufactured by Hitachi Chemical Co., Ltd. was used as the sealing material.

The thus obtained measurement sample was set on the heat stage of a shear strength measurement device (Universal Bond Tester 4000 (Dage 4000)) manufactured by Nordson Advanced Technology Corporation. Measurement was conducted under conditions including temperature conditions of 25°C, 150°C and 250°C, and a probe speed of 5 mm/min, and the adhesive strength was evaluated based on the shear strength values.

**[Table 1]**

| | Resin composition | Viscosity (mPa·s) | Tg (°C) | Elastic modulus (GPa) | Adhesive strength (shear strength /MPa) | | |
|---|---|---|---|---|---|---|---|
| | | | | | 25°C | 150°C | 250°C |
| Example 1 | P-1 | 210 | 287°C | 2.6 | 38 | 32 | 26 |
| Example 2 | P-2 | 280 | 291°C | 2.7 | 36 | 30 | 22 |
| Example 3 | P-3 | 181 | 290°C | 2.6 | 35 | 32 | 25 |
| Example 4 | P-4 | 161 | 259°C | 2.9 | 30 | 28 | 20 |
| Comparative Example 1 | P-5 | 177 | 220°C | 2.1 | 29 | 20 | 5 |
| Comparative Example 2 | P-6 | 162 | 216°C | 2.0 | 25 | 23 | 5 |
| Comparative Example 3 | P-7 | 180 | 204°C | 1.9 | 24 | 21 | 5 |
| Comparative Example 4 | P-8 | 191 | 241°C | 2.2 | 30 | 25 | 9 |

As is evident from Table 1, in Examples 1 to 4 that represented embodiments of the present invention, the glass transition temperature (Tg) of the polyamideimide resin was 250°C or higher in each case. Further, in each case, the viscosity exceeded 160 mPa·s, the elastic modulus exceeded 2.2 GPa, and favorable results were also obtained for the printability and flexibility. Moreover, it is also evident that in each of Examples 1 to 4, excellent adhesive strength (shear strength) of at least 20 MPa was able to be maintained even at a high temperature of 250°C.

In contrast, compared with Examples 1 to 4, the polyamideimide resin compositions of Comparative Examples 1 to 4 each had a lower Tg value and exhibited inferior results for the viscosity, the elastic modulus and the adhesive strength. With regard to the adhesive strength, a tendency for reduced adhesive strength with increasing temperature was observed, but it was also evident that particularly in the case of the adhesive strength of Comparative Examples 1 to 4 at 250°C, the results were less than 10 MPa, representing a dramatic reduction compared with the results for Examples 1 to 4.

Based on the above results, it is evident that in power semiconductor devices that are exposed to high temperatures during operation, the problems caused by a deterioration in adhesive strength during heat cycle testing, which require improvement, can be addressed by the present invention.

### DESCRIPTION OF THE REFERENCE SIGNS

1: Substrate (lead frame)
1a: Die pad
1b: Lead
2: Semiconductor element
3: Primer layer (polyamideimide resin composition)
4: Wire
5: Resin sealing member

## Claims

1. A polyamideimide resin comprising a structural unit (Ia) derived from a compound represented by formula (I) and a structural unit (IIa) derived from a compound represented by formula (II), and having a glass transition temperature of 250°C or higher: 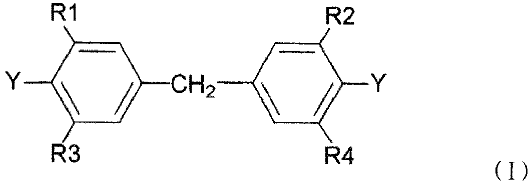 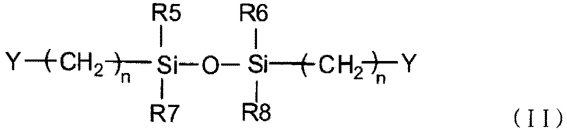 wherein within formula (I) and formula (II),
each of R1 to R4 in formula (I) independently represents an alkyl group of 3 to 9 carbon atoms having a branched structure, each of R5 to R8 in formula (II) independently represents an alkyl group of 1 to 3 carbon atoms, and
each Y independently represents an amino group or an isocyanate group.

2. The polyamideimide resin according to Claim 1, further comprising a structural unit (IIIa) derived from a compound represented by formula (III): 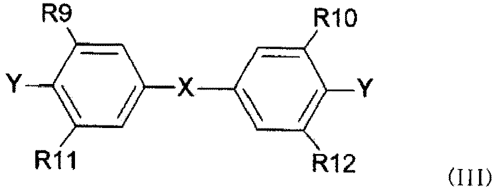 wherein within formula (III),
each of R9 to R12 independently represents a hydrogen atom, or at least one substituent selected from the group consisting of alkyl groups of 1 to 9 carbon atoms, alkoxy groups of 1 to 9 carbon atoms and halogen atoms,
X represents a linking group selected from the group consisting of -O-, -S-, -SOz-, -C(=O)- and -S(=O)-, and
each Y represents an amino group or an isocyanate group.

3. The polyamideimide resin according to Claim 1 or 2, further comprising a structural unit (IVa) derived from trimellitic anhydride or an acid halide thereof represented by formula (IV): 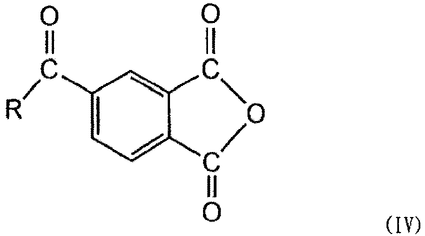 wherein R represents a hydroxyl group or a halogen atom.

4. A polyamideimide resin composition comprising the polyamideimide resin according to any one of Claims 1 to 3, and a solvent capable of dissolving the polyamideimide resin.

5. The polyamideimide resin composition according to Claim 4, further comprising a coupling agent.

6. The polyamideimide resin composition according to Claim 4 or 5, wherein in a laminate obtained by forming a primer layer on a substrate using the polyamideimide resin composition, and then molding a resin sealing member on top of the primer layer, the shear strength at 250°C between the substrate and the resin sealing member is at least 10 MPa.

7. The polyamideimide resin composition according to any one of Claims 4 to 6, wherein an elastic modulus at 35°C of a film obtained using the polyamideimide resin composition is within a range from 0.5 GPa to 3.0 GPa.

8. The polyamideimide resin composition according to any one of Claims 4 to 7, further comprising a pigment.

9. The polyamideimide resin composition according to Claim 8, wherein the pigment is a white-colored powder.

10. The polyamideimide resin composition according to Claim 8 or 9, wherein an average particle size of the pigment is less than 100 µm.

11. A semiconductor device formed using the polyamideimide resin according to any one of Claims 1 to 3 or the polyamideimide resin composition according to any one of Claims 4 to 10.

12. A semiconductor device having a substrate, a semiconductor element mounted on the substrate, a primer layer provided on a semiconductor element-mounting surface of the substrate, and a resin sealing member provided on top of the primer layer, wherein
the primer layer is formed using the polyamideimide resin according to any one of Claims 1 to 3 or the polyamideimide resin composition according to any one of Claims 4 to 10.

## Patentansprüche

1. Polyamidimidharz, umfassend eine Struktureinheit (Ia), die sich von einer durch Formel (I) dargestellten Verbindung ableitet, und eine Struktureinheit (IIa), die sich von einer durch Formel (II) dargestellten Verbindung ableitet, und mit einer Glasübergangstemperatur von 250°C oder höher: 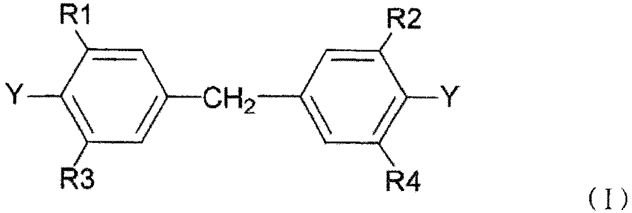 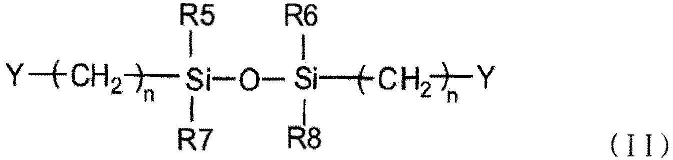
wobei in Formel (I) und Formel (II)
jedes von R1 bis R4 in Formel (I) unabhängig eine Alkylgruppe mit 3 bis 9 Kohlenstoffatomen mit einer verzweigten Struktur darstellt, jedes von R5 bis R8 in Formel (II) unabhängig eine Alkylgruppe mit 1 bis 3 Kohlenstoffatomen darstellt und
jedes Y unabhängig eine Aminogruppe oder eine Isocyanatgruppe darstellt.

2. Polyamidimidharz gemäß Anspruch 1, ferner umfassend eine Struktureinheit (IIIa), die sich von einer durch Formel (III) dargestellten Verbindung ableitet: 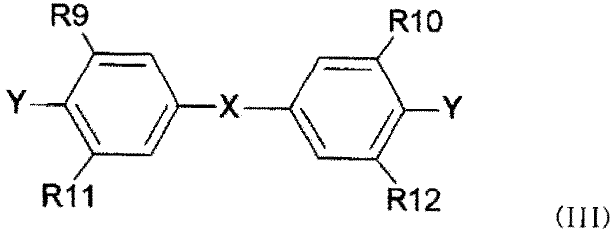
wobei in Formel (III)
jedes von R9 bis R12 unabhängig ein Wasserstoffatom oder mindestens einen Substituenten, ausgewählt aus der Gruppe, bestehend aus Alkylgruppen mit 1 bis 9 Kohlenstoffatomen, Alkoxygruppen mit 1 bis 9 Kohlenstoffatomen und Halogenatomen, darstellt,
X eine Verknüpfungsgruppe, ausgewählt aus der Gruppe, bestehend aus -O-, -S-, -SO₂-, -C(=O)- und -S(=O)-, darstellt und
jedes Y eine Aminogruppe oder eine Isocyanatgruppe darstellt.

3. Polyamidimidharz gemäß Anspruch 1 oder 2, ferner umfassend eine Struktureinheit (IVa), die sich von Trimellitsäureanhydrid oder einem Säurehalogenid davon, dargestellt von Formel (IV), ableitet: 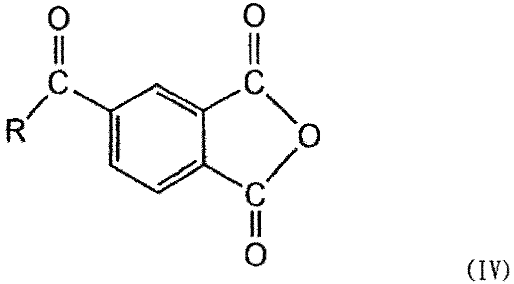 worin R eine Hydroxylgruppe oder ein Halogenatom darstellt.

4. Polyamidimidharzzusammensetzung, umfassend das Polyamidimidharz gemäß einem der Ansprüche 1 bis 3 und ein Lösungsmittel, das zum Lösen des Polyamidimidharzes geeignet ist.

5. Polyamidimidharzzusammensetzung gemäß Anspruch 4, ferner umfassend einen Haftvermittler.

6. Polyamidimidharzzusammensetzung gemäß Anspruch 4 oder 5, wobei in einem Laminat, das durch Bilden einer Grundierungsschicht auf einem Substrat unter Verwendung der Polyamidimidharzzusammensetzung und dann Formen eines Harzabdichtungselements auf der Grundierungsschicht erhalten wird, die Scherfestigkeit bei 250°C zwischen dem Substrat und dem Harzabdichtungselement mindestens 10 MPa beträgt.

7. Polyamidimidharzzusammensetzung gemäß einem der Ansprüche 4 bis 6, wobei ein Elastizitätsmodul bei 35°C einer Folie, die unter Verwendung der Polyamidimidharzzusammensetzung erhalten wird, in einem Bereich von 0,5 GPa bis 3,0 GPa liegt.

8. Polyamidimidharzzusammensetzung gemäß einem der Ansprüche 4 bis 7, ferner umfassend ein Pigment.

9. Polyamidimidharzzusammensetzung gemäß Anspruch 8, wobei das Pigment ein weißgefärbtes Pigment ist.

10. Polyamidimidharzzusammensetzung gemäß Anspruch 8 oder 9, wobei eine durchschnittliche Partikelgröße des Pigments weniger als 100 µm beträgt.

11. Halbleitervorrichtung, die unter Verwendung des Polyamidimidharzes gemäß einem der Ansprüche 1 bis 3 oder der Polyamidimidharzzusammensetzung gemäß einem der Ansprüche 4 bis 10 gebildet ist.

12. Halbleitervorrichtung mit einem Substrat, einem Halbleiterbauelement, das auf dem Substrat montiert ist, einer Grundierungsschicht, die auf einer Oberfläche des Substrats, auf der das Halbleiterbauelement montiert ist, vorhanden ist, und einem Harzabdichtungselement, das auf der Grundierungsschicht vorhanden ist, wobei
die Grundierungsschicht unter Verwendung des Polyamidimidharzes gemäß einem der Ansprüche 1 bis 3 oder der Polyamidimidharzzusammensetzung gemäß einem der Ansprüche 4 bis 10 gebildet ist.

## Revendications

1. Résine de polyamideimide comprenant un motif de structure (la) dérivé d'un composé représenté par la formule (I) et un motif de structure (IIa) dérivé d'un composé représenté par la formule (II), et présentant une température de transition vitreuse de 250 °C ou plus : 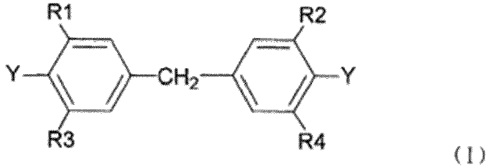 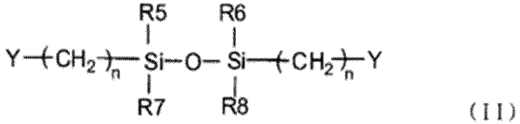 dans laquelle dans la formule (I) et la formule (II),
chacun parmi R1 à R4 dans la formule (I) représente indépendamment un groupe alkyle de 3 à 9 atomes de carbone présentant une structure ramifiée, chacun parmi R5 à R8 dans la formule (II) représente indépendamment un groupe alkyle de 1 à 3 atomes de carbone, et
chaque Y représente indépendamment un groupe amino ou un groupe isocyanate.

2. Résine de polyamideimide selon la revendication 1, comprenant en outre un motif de structure (Illa) dérivé d'un composé représenté par la formule (III) : 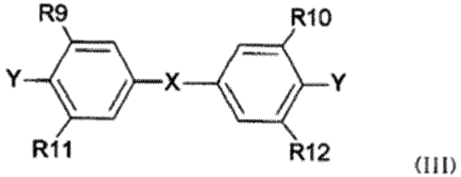 dans laquelle dans la formule (III),
chacun parmi R9 à R12 représente indépendamment un atome d'hydrogène, ou au moins un substituant sélectionné dans le groupe consistant en les groupes alkyle de 1 à 9 atomes de carbone, les groupes alcoxy de 1 à 9 atomes de carbone et les atomes d'halogène,
X représente un groupe de liaison sélectionné dans le groupe consistant en - O-, -S-, -SO₂-, -C(=O)- et -S(=O)-, et
chaque Y représente un groupe amino ou un groupe isocyanate.

3. Résine de polyamideimide selon la revendication 1 ou 2, comprenant en outre un motif de structure (IVa) dérivé de l'anhydride trimellitique ou d'un halogénure d'acide de celui-ci représenté par la formule (IV) : 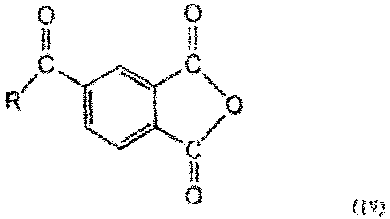 dans laquelle R représente un groupe hydroxyle ou un atome d'halogène.

4. Composition de résine de polyamideimide comprenant la résine de polyamideimide selon l'une quelconque des revendications 1 à 3, et un solvant capable de dissoudre la résine de polyamideimide.

5. Composition de résine de polyamideimide selon la revendication 4, comprenant en outre un agent de couplage.

6. Composition de résine de polyamideimide selon la revendication 4 ou 5, dans laquelle, dans un stratifié obtenu en formant une couche primaire sur un substrat en utilisant la composition de résine polyamideimide, et ensuite en moulant un élément d'étanchéité en résine au-dessus de la couche primaire, la résistance au cisaillement à 250 °C entre le substrat et l'élément d'étanchéité en résine est d'au moins 10 MPa.

7. Composition de résine de polyamideimide selon l'une quelconque des revendications 4 à 6, dans laquelle un module d'élasticité à 35 °C d'un film obtenu en utilisant la composition de résine de polyamideimide est dans une plage de 0,5 GPa à 3,0 GPa.

8. Composition de résine de polyamideimide selon l'une quelconque des revendications 4 à 7, comprenant en outre un pigment.

9. Composition de résine de polyamideimide selon la revendication 8, dans laquelle le pigment est une poudre de couleur blanche.

10. Composition de résine de polyamideimide selon la revendication 8 ou 9, dans laquelle la taille moyenne de particule du pigment est inférieure à 100 µm.

11. Dispositif à semi-conducteur formé en utilisant la résine de polyamideimide selon l'une quelconque des revendications 1 à 3 ou la composition de résine de polyamideimide selon l'une quelconque des revendications 4 à 10.

12. Dispositif à semi-conducteur présentant un substrat, un élément semi-conducteur monté sur le substrat, une couche primaire fournie sur une surface de montage d'élément semi-conducteur du substrat, et un élément d'étanchéité en résine fourni au-dessus de la couche primaire, dans lequel
la couche primaire est formée en utilisant la résine de polyamideimide selon l'une quelconque des revendications 1 à 3 ou la composition de résine de polyamideimide selon l'une quelconque des revendications 4 à 10.
